# EUROPEAN PATENT APPLICATION

(11) **EP 2 148 211 A1**
(43) Date of publication of application: **27.01.2010**
(21) Application number: 08013352.3
(22) Date of filing: 24.07.2008
(51) Int. Cl.: G01R 31/28

(54) **Apparatus and method for transferring electronic devices to and from a test position**

(71) Applicant: DEK International GmbH, 8005 Zürich (CH)
(72) Inventor: Waldauf, Alexander, Dr., 83059 Kolbermoor (DE)
(74) Representative: Boden, Keith McMurray

(57) **Abstract**

The invention concerns a rotary type handler for handling electronic devices for testing, comprising at least two carrier portions (14, 16, 25, 26, 45, 46, 54, 56, 65, 84, 86) each for transferring devices (3) from a loading position (L) to a test position (T) and from there to an unloading position (U), wherein each carrier portion is mounted rotatable wherein, the at least two carrier portions can rotate independently of each other.

## Description

The invention described in this document relates to the task of transferring electronic devices to and from a test position, at which the devices can be tested with respect to their electronic or electric properties. Various handlers are known that include a means for transporting devices to and from a test position, and apparatuses for loading and for unloading the transport means. The respective transport means includes one or more carrier portions, which transfer devices along a path from a loading position to a test position and, after the devices have been tested, to an unloading position. Further positions as e.g. an optical control element can be included in the path. In a rotary type handler carrier portions are mounted rotatable. An example thereof is a turret handler in which devices are transferred by means of carrier portions, which are attached to a turret for rotating the carrier portions. Document EP 0 269 889 shows a rotary turret device for testing electronic components.

An important property of a handler is its throughput of devices, i.e. the number of devices that can be loaded, tested and unloaded per time unit. This value depends on the so-called index time, which is defined as the time needed by the handler to exchange two devices in the test position. Various apparatuses and methods have been designed to provide for an index time as short as possible.

The present invention refers to the problem of how a rotary type handler and a method can be designed such that a high throughput can be achieved.

A solution is given by the rotary type handler of claim 1 and the method of claim 13. Preferred embodiments are disclosed in the dependent claims.

In a rotary type handler carrier portions are mounted rotatable for transferring devices. A carrier portion of a handler is any part of the handler that serves for holding and transferring one or more devices. Due to two of those carrier portions being able to rotate independently of each other the loading or unloading of the carrier portions or the testing of the devices or the transfer of the devices by the carrier portions can be carried out in a flexible manner. For example while one carrier portion is in a test position, in which it remains fixed over a certain amount of time without moving, the other carrier portion may rotate in order to transfer devices or in order to load or unload devices.

The two carrier portions can rotate independently of each other (during a turn of the carrier portions) for transferring devices from a loading position to a test position and from there to an unloading position. This includes the case where the independency is given only over a certain part of turn of a carrier portion. For example, it may be the case that a first carrier portion, which is mounted rotatable, can rotate by a certain angle, whereas a second carrier portion, which is mounted rotatable, does not rotate in the same way. Further, it may be the case that the first carrier portion cannot overtake the second carrier portion, although they can rotate independently over a certain range. In each turn of a carrier portion it passes by at least a loading position, a test position and an unloading position. The direction of movement in a turn is always the same such as clockwise or counter clockwise.

The unloading position is preferably different from the loading position, which means that the carrier portions can be loaded at one position and can be unloaded at another position. The carrier portion can move empty from the unloading position to a loading position.

Since the carrier portions are mounted rotatable, upon rotation thereof they also change their orientation with respect to the different serving positions such as the loading, unloading or test position.

Each carrier portion may rotate around an axis of rotation (which is an abstract geometrical line) of the carrier portion. This motion may be a circular motion, i.e. in one plane or include a motion component along the axis of rotation. The axes of rotation of the two carrier portions, which can rotate independently of each other, may coincide or be parallel to each other.

Each carrier portion can, in addition to a rotational movement move radially. Such a movement may be accomplished by additional means which can move a carrier outwards or inwards with respect to the rotation.

One turn of a carrier portion may comprise rotational movements along a circle, or along a portion of a helix. These movements may be combined with a movement inwards or outwards with respect to the rotation. During one turn there may be also movements, which are only inwards/outwards (such as radial) without any rotation or there may be movements only along an axis of rotation without a combined rotational movement.

The rotary type handler provides various advantages: As an example, the testing procedure might take more time than the complete loading of a carrier portion with one or more devices. In this situation a first carrier portion can not only be loaded during a time interval in which a second carrier portion is being operated at the test position, but during the same interval, i.e. when the one or more devices of the second carrier portion are still being tested, the loaded first carrier portion can rotate such that the first carrier portion moves towards the test position. Therefore, once the testing of the devices of the second carrier portion is finished, the first carrier portion might already be situated at a waiting position immediately close to the test position, so that the time between tested devices being removed from the test position and new devices being supplied to it, is reduced. This provides for a beneficially short index time of the handler. Analogous advantages result from other time relations of the positions (e.g. if the loading position requires more time than the unloading or the testing position or the like), in which cases respective waiting positions close to the loading and/ or unloading position can be assumed by a carrier portion.

An appropriate location of a waiting position with respect to the respective serving position (i.e., the testing, loading or unloading position) can provide for an efficient motion flow. If a carrier portion has to move at a serving position (e.g., an insertion movement at the test position might be necessary), the respective waiting position may be located such that the movement from this waiting position to the respective serving position and the movement at the serving position can be combined into one single, unidirectional motion. This can both shorten the index time and simplify the management of the movements. For instance, a downward movement parallel to a rotation axis might be necessary for plugging in the devices to be tested. In this case, if the waiting position for the tester is located for example above the test position, the movement from the waiting position to the test position and the plugging-in both can be done by one single down stroke. Analogous advantages result if the plug in movement is a radial one and the waiting position is radially further inward than the test position.

A further increase of throughput can be achieved by having a carrier portion, which is to be moved to the test position in a position, which is not immediately next to the test position such as the waiting position, but further away from the test position. In case that the moment in which a carrier portion will be removed from the test position is known in advance, the carrier portion which is waiting can start to move towards the test position without, however, the other carrier portion yet having started to leave the test position. The movement of the two carrier portions can be programmed such that just as one carrier portion starts to leave the test position the other carrier portion arrives in motion at the test position. In this way, the time needed to accelerate a carrier portion from the waiting position can be saved.

The rotatable mounting of the one or more carrier portions of a rotary type handler can be technically realised by coupling each carrier portion with a turret that is mounted rotatable and which preferably transmits its rotation movement to the coupled carrier portion. In this case at least two turrets are provided each coupled to one carrier portion. It may also be realized by mounting the carrier portion movable with respect to a fixed part such as e.g. a rail with defines a closed path on which the carrier portions can move or circulate.

Each turret can rotate around a rotation axis. The movement of the turret can also include motions parallel to the rotation axis. The respective rotation axes of two turrets preferably coincide, so that both turrets rotate with respect to the same rotation axis. Alternatively, the two rotation axes may be distinct of each other, in which case they are, however, preferably parallel.

Said coupling of a carrier portion with a turret, which is mounted rotatable can be accomplished by the carrier portion being integrated in the turret, i.e., so that the carrier portion and said turret are one of a piece. However, the carrier portion may also be a component, which is connected directly or indirectly with the turret that is mounted rotatable. Each carrier portion revolves around the rotation axis of the corresponding coupled turret.

The turrets which are mounted rotatable may have the shape of a disk, in particular of a circular disk or of a disk in the shape of a triangle. Alternatively, they may have the shape of a star.

A movement of a carrier portion from a waiting position to a test position (with or without the movement of the devices for plugging them in) can be driven by the respective carrier portion itself (i.e. while the turret remains fixed), or by the coupled turret, which then transmits its motion to the carrier portion.

For holding the device(s), a carrier portion can include one or more suction heads that can hold either single devices or bundles thereof. On the other hand, a carrier portion can also include one or more sub portions (such as slots) to hold the device(s), into which devices can be dropped, making use of gravity.

Moreover, the rotary type handler can be constructed such that the corresponding rotation axis of the carrier portions or the turrets is oriented vertically, but also so that other orientations are possible. In particular, the axis can also be horizontal.

Each of the at least two carrier portions that can rotate independently of each other can have one or more further carrier portions coupled therewith, such that all carrier portions coupled with each other have a fixed relation with each other. Such related carrier portions are called associated with each other. In such an embodiment, the carrier portions associated with each other cannot rotate independently of each other, which means that the rotation of one carrier portion causes the rotation of another carrier portion. A handler that is designed in this manner includes more than two carrier portions, where the position of each of the carrier portions determines the position of its associated carrier portion(s). Therefore, on the one hand, various positions can be operated at the same time, which increases the throughput of the handler. On the other hand, the fixed relation provides a relatively easy management of the respective rotation of the multiple carrier portions, because the coupled movements of carrier portions associated with each other can be commonly controlled. Preferably, the carrier portions are provided with a rotational symmetry, which means that e.g. each 180° (two fold symmetry), 120° (threefold symmetry) or 90° (four-fold symmetry) a carrier portion is provided.

A first carrier portion and its respective associated carrier portion(s) can be coupled with each other such that the test position, the loading position and the unloading position can be reached and operated at the same time. Therewith, the throughput can be increased. Additionally, in this situation, a second carrier portion (which can rotate independently of the first one) can rotate, causing the carrier portions associated therewith to move to respective waiting positions close to the test position, the loading position and the unloading position, respectively. This provides a combination of the advantages mentioned above, i.e. time saving by providing waiting positions on the one hand and increased throughput and easy management by different carrier portions being associated with each other.

The waiting, testing, loading and unloading positions may all be situated at the same distance to an axis of rotation. Alternatively, if the carrier portions can be moved outwards radially to the axis, the distances of the respective positions to the rotation axis may vary. For example, the test, loading and unloading position can be situated on a first circle, and the respective waiting positions can be located on a second circle that is concentric to the first one. Alternatively or in addition, if the carrier portion's path includes a movement parallel to the rotation axis of a carrier portion or a turret, the respective waiting positions can be situated accordingly. For instance, the loading, testing and unloading position can be situated on a first plane that is orthogonally intersected by the rotation axis of a carrier portion or a turret, whereas the waiting positions are all situated on a second plane that is parallel to the first one.

In one embodiment, the carrier portions associated with each other are situated such that two of the serving positions can be reached at the same time, whereas the third position cannot be reached at this same time. Stated differently, the three serving positions can be arranged such that two of them can simultaneously be reached by carrier portions associated with each other, whereas the third cannot. For instance, the loading and the unloading position might be reachable at the same time, while the test position is not. In this embodiment, the test position could be served by a first carrier portion. Contemporaneously, a second carrier portion could be loaded while a carrier portion associated therewith is being unloaded. In this way, the movement of the respective carrier portions can be adapted to the respective requirements of the testing procedure on the one hand and the loading and unloading procedure on the other hand, without conflicting with each other. The possible need of such particular movements is explained next.

Each carrier portion can be designed for transferring various devices at the same time. In addition, the test apparatus can be adapted for testing various devices simultaneously. The loading capacity of a carrier portion, i.e. the number of devices that can be simultaneously transferred by a carrier portion, can be such that it coincides with the number of devices that can be tested at the same time. Alternatively, the loading capacity can be such that it exceeds the number of devices that are contemporaneously testable in one test position. In the latter case, the carrier portion can be planned to move for serving the test apparatus in different steps thereby having two different test positions for serving one and the same test apparatus. In any case, if the carrier portions can simultaneously transfer various devices, the throughput of the handler can be increased, i.e. its efficiency can be improved.

If each carrier portion can transfer several devices simultaneously, a further advantage of the fact that at least two carrier portions can rotate independently of each other becomes apparent. Indeed, as one carrier portion can be moved to be operated in different steps at one position, while another carrier portion has to remain immobile or move asynchronously with respect to the first carrier portion, the efficiency of the respective operation can be upgraded. For instance, the loading or unloading operation might be improved by a carrier portion's motion, which is caused by a rotation thereof, e.g. for loading or unloading in various consecutive steps as detailed below. Due to the present invention, such a rotation is not prevented by the fact that another carrier portion, which holds devices that are being tested, has to remain fixed during a certain time interval. Analogously, testing of devices carried by one carrier portion can be made possible in various steps requiring a rotation of the carrier portion, even if the contemporaneously operated loading and unloading procedures require a different movement or a halt.

More than 1 or 3 devices may advantageously be provided on a single line of positions for devices of a carrier portion while more than 5 or 10 devices may be provided in a two-dimensional array of positions for devices of a carrier portion.

The advantage of a plurality of devices being transferred with one carrier portion at once may be taken by designing the carrier portions such that each can simultaneously transfer several devices, which all follow one after the other upon rotation of the carrier portion. They may for example all follow the same path, at least over a portion of a carrier portion's turn. They may for example all have the same distance to a rotation axis of the carrier portion or of the turret respectively coupled with the carrier portion (measured at a point in time, i.e. when the respective carrier portion is not moving).

Alternatively or additionally, each carrier portion can be designed such that it can transfer several devices along different path one of which is further inward than another path upon rotation of the carrier portion. They may for example have different distances to said rotation axis of the carrier portion or the turret. Further, they may be located on positions, which have different paths that are parallel to each other, but none of them being further inward or outward. The devices may, for example, be provided along a line which lies parallel to a rotation axis of a carrier portion or a turret. The latter can be convenient, in particular, if the handler is loaded by making use of gravity. In all these cases, the arrangement of devices within a carrier portion can be advantageous for an efficient loading or unloading procedure.

The loading of a carrier portion can be performed in different modes. For example, it is possible to load all devices simultaneously in one step or to load one carrier portion with devices in different consecutive steps wherein in each step one group of devices is loaded. The devices of a group can be loaded all at once or one after the other. It is also possible to load all devices one after the other. The devices of a group can be loaded in a row of an array of positions for devices. One row of that array may be arranged essentially perpendicular to the movement direction of the devices upon rotation of the carrier portion. Thereby it is possible to rotate the carrier portion step wise for loading devices always in the same place, but into different rows. This allows for a relatively easy way of loading multiple devices into a carrier portion, which can be rotated, for being loaded with devices.

In case that the devices are loaded one by one or in various groups a first step may include loading the carrier portion with a device/group at a most inward position (first position), and thereafter with one at a more outward position than the first position. A second step may then include loading a further device or group of devices at another most inward position and afterwards at another more outward position. For each device loading, a shuttle may supply the respective device to its respective position. The loading order as described can then make the shuttle movement more efficient.

In a further embodiment, devices can be supplied to a certain fixed loading point, and the carrier portion or a sub-portion thereof (as, e.g., a suction head) can be moved to pick up a device from said point. That is, in this case, even placing devices at different locations within a carrier portion is realised only by moving the carrier portion, whereas no movement of a part of the ambient assembly at the loading position (including the bowl feeder) is necessary in order to specifically supply the devices to different locations within the carrier portion. Any movement of the devices caused by the ambient assembly supplies the devices to one and the same position, independently of the final location of the devices within the carrier portion. The carrier portion can be rotated for being loaded with devices without, however, having to move another carrier portion which may be held fixed in a testing position, providing the advantages as described above, or it can also be moved in an inward/outward direction (such as in a radial direction with respect to a rotation axis) or parallel to a rotation axis.

In one embodiment various devices are placed in a pallet, which is supplied to and taken by a carrier portion as a whole. Therewith, the loading procedure of a carrier portion is reduced to one simple picking step, where the loading of the pallet itself is can be undertaken at a position remote from the handler. Therefore, the rhythm of supplying devices to the carrier portion can be adapted to the time needed for testing, such that no time is lost by waiting for devices to be loaded while the tester is idle.

Analogous advantages arise when the pallet is unloaded as a whole, for the devices carried therein to be sorted responsively to the test result at a position remote from the handler.

The method includes transferring one or more devices by a first and a second carrier portion, wherein both carrier portions can rotate independently of each other, and wherein both carrier portions each transfer one or more devices from a loading position to a test position and, after the one or more transferred devices have been tested, to an unloading position. This method provides the advantages described above.

In the drawings, some exemplary embodiments of the invention and some explanatory illustrations are given:

Fig. 1 shows a three dimensional view of an embodiment of the present invention.

Fig. 2 a schematically illustrates how different positions can be located for devices to pass through.

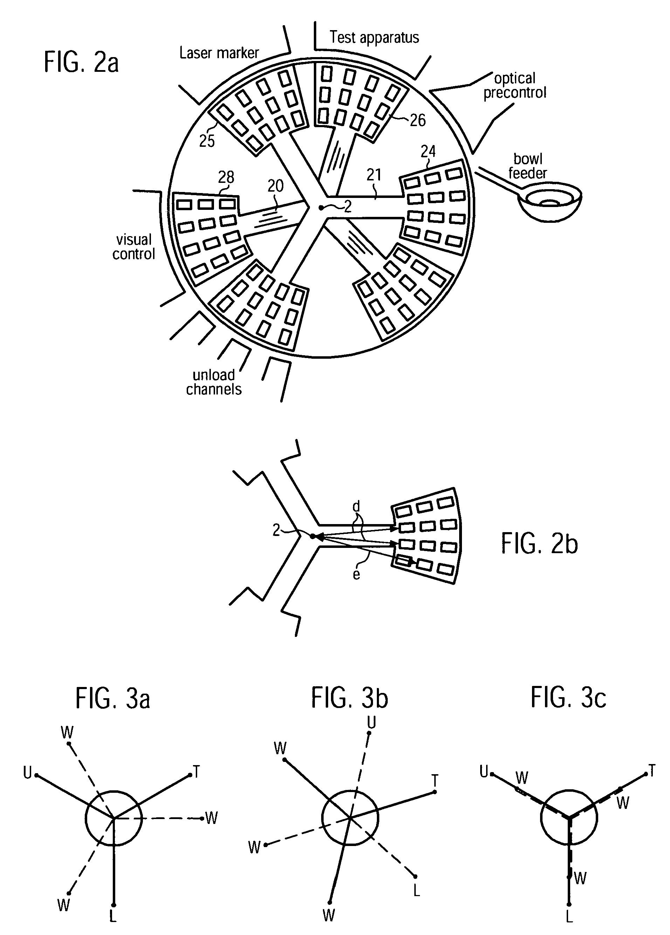

Fig. 2 b schematically shows different positions of devices within a carrier portion.

Fig. 3a, b and c schematically depict three possibilities of arranging a test position, a loading position, an unloading position and waiting positions in a preferred embodiment.

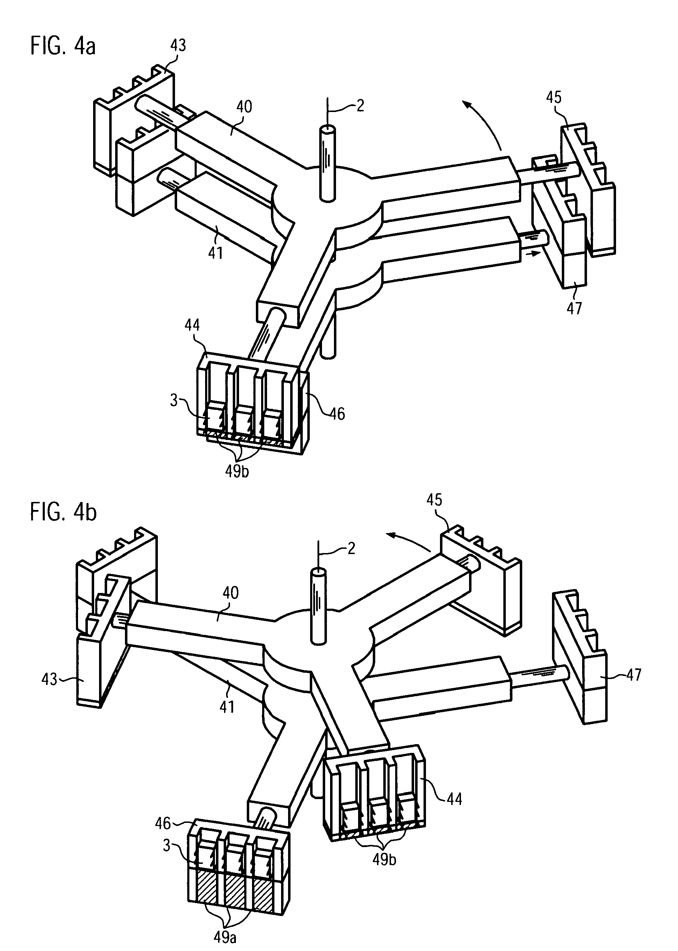

Fig. 4 a and b illustrate two operating situations of an exemplary embodiment.

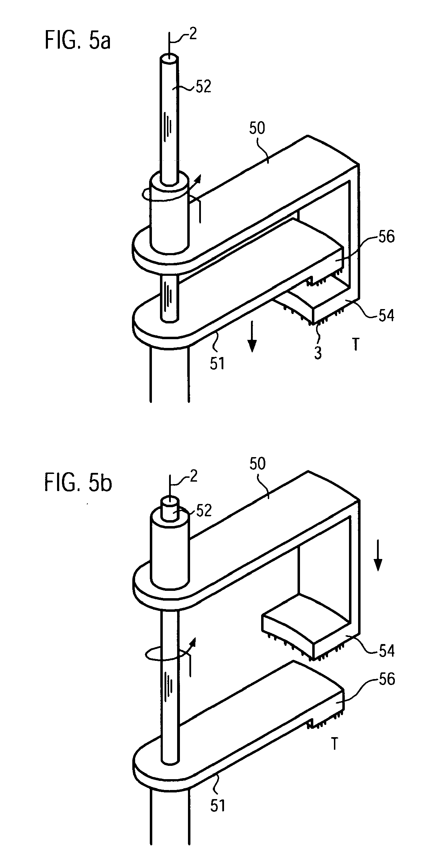

Fig. 5 a and b are two views of another exemplary embodiment in different moments.

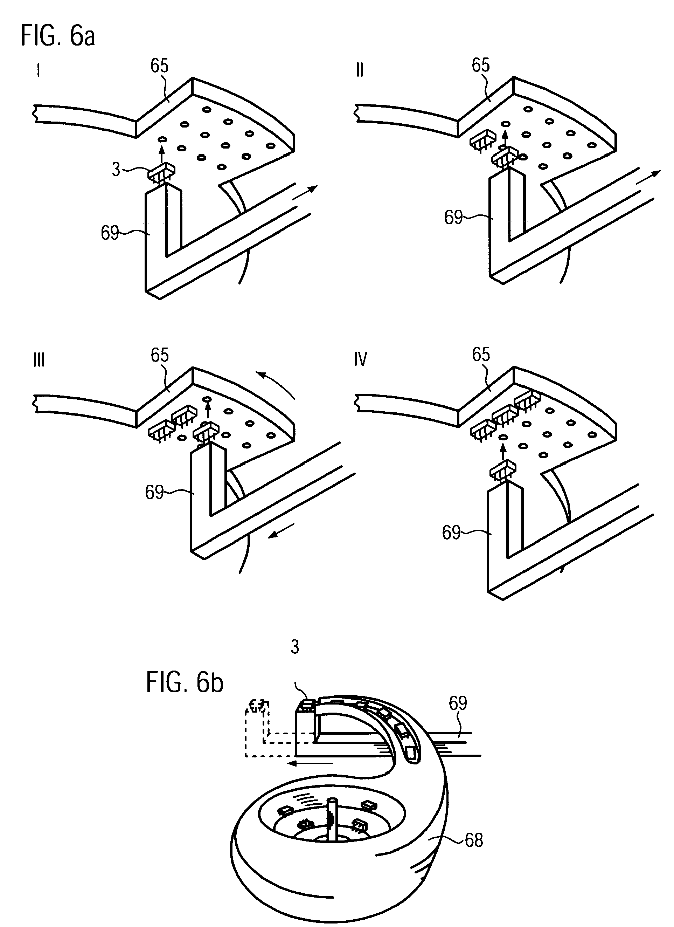

Fig. 6 a and b indicate four steps of a possible manner to load a carrier portion of an exemplary rotary type handler and a possible way of supplying a loading shuttle with a device.

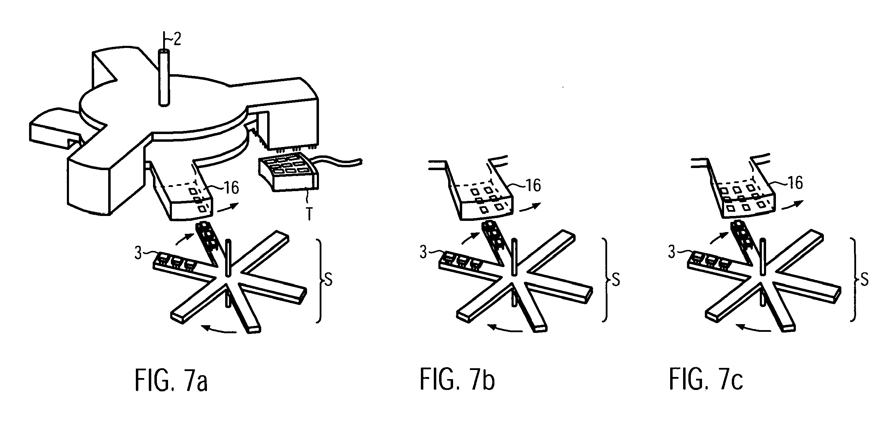

Fig. 7 shows three operating steps of alternatively loading a carrier portion of an embodiment of a rotary type handler.

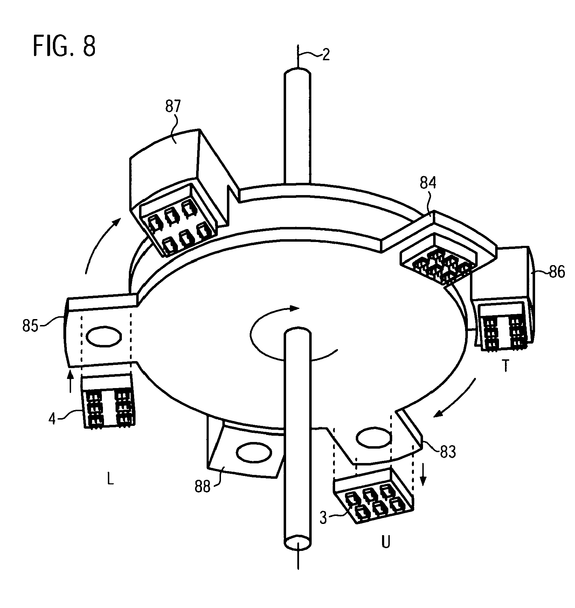

Fig. 8 illustrates an embodiment of an exemplary rotary type handler for transferring devices in pallets.

Even though the carrier portions of the rotary type handlers shown in the various figures are indicated to rotate with respect to a certain direction (counter clockwise or clockwise), in conjunction with the respective operating positions they could just as well be designed to rotate the other way round. They do, however, only rotate in one of the two directions (clockwise or counter clockwise).

Except the case shown in Figure 5, all depicted embodiments are such that every carrier portion has two further carrier portions associated therewith. However, the invention also includes handlers for which a carrier portion has none, one, three or more carrier portions associated therewith.

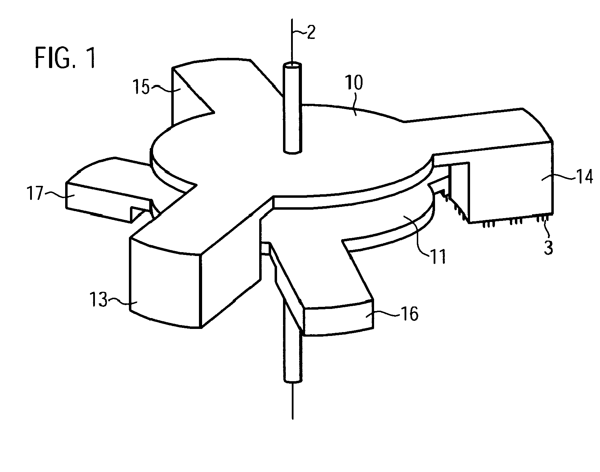

In Figure 1, the rotating parts of an exemplary rotary type handler are shown. It includes two carrier portions 14 and 16, each of which is associated with two further carrier portions. The carrier portions associated with each other are extensions of a respective disk 10 and 11 each of which is mounted rotatable. These disks can rotate independently of each other. In the example of Fig. 1, the two disks can rotate with respect to a common rotation axis 2. Each disk could be driven by a motor, which preferably would be a step or servo motor. This provides for a high degree of flexibility at the time of programming the rotation of the different disks (and, therewith, of the carrier portions). The axis of rotation 2 is the axis of rotation of the disks 10, 11 and also of the carrier portions 13-17.

Instead of the carrier portions 13 to 17 being extensions of the disk 10, 11 they may also be mounted on a rail which allows movement of the carrier portions on a closed path. This rail is then fixed and the carrier portions move along the rail.

Carrier portion 14, as illustrated, is loaded on the bottom with devices 3. For this purpose, each carrier portion could have a plurality of suction heads which each can hold a device at the lower end or on a lower surface of the carrier portion. The suction heads could be such that they may be operated independently of each other, and such that they may be moved downwards to pick up a device, which then can be lifted by retracting the suction head upwards. Carrier portion 14 and the carrier portions 13 and 15 associated therewith have a larger extension in a direction along the rotation axis 2 than carrier portion 16 and the carrier portions associated with it, such that the respective devices 3 are carried all on the same level or plane, although the disks 10 and 11 are on different levels with respect to the rotation axis 2.

In case of Fig. 1, the two turrets are given by the disks 10 and 11. The disk 11 can, for example, be rotated in a counter clockwise direction such that the carrier portion 16 rotates to the right in Fig. 1. During this movement, the disk 10 or the carrier portion 14 does not have to move since the rotation thereof is independent. The carrier portion 16, however, cannot overtake the carrier portion 14 since it would collide with it when moved too far. In this way the carrier portion 16 can rotate independent of the carrier portion 14.

Further, the two disks 10, 11 are mounted rotatable with respect to the same axis of rotation 2. They may nevertheless also be slightly set off with respect of each other. On each disk 10, 11 the carrier portions are provided in a three fold symmetry.

Each disk 10, 11 may be movable along the axis of rotation 2. Thereby the devices 3 may for example be plugged into a test apparatus. Such a movement may also be used for picking up devices (loading) or for unloading them. The test apparatus does generally not form part of the handler but will be served by the handler.

Figure 2a shows schematically how a turret or associated carrier portions and respective serving positions can be located with respect to each other. Therein, a moment of the operating cycle of the rotary type handler is depicted. During a whole cycle, each of the represented carrier portions will pass each of the stations bowl feeder, optical pre-control, test apparatus, laser marker, visual control and unload channels.

Each carrier portion shown in Figure 2a is designed to simultaneously carry twelve devices, the present invention likewise covers embodiments wherein the carrier portions are adapted to carry more or less than twelve devices. In the situation presented in Figure 2a, a carrier portion 24 is located at a loading position, where it is loaded with devices being supplied by a bowl feeder. When rotating later on, the carrier portion will pass an optical precontrol station.

At the time in which carrier portion 24 is being loaded, another carrier portion 26, which can rotate independently of the carrier portion 24, is situated at a test position, next to a test apparatus. In this position, the electronic properties of the device can be tested or evaluated by the test apparatus. A further carrier portion 25, which has a fixed relation with carrier portion 24, is situated at a laser marker station, which serves to mark the tested devices responsively to the test result, for sorting them later on. Before the carrier portions are unloaded, they pass a further visual control station. In the shown moment of the cycle, devices of carrier portion 28 are being checked at this station. At the unload position, three different channels are shown, each of which might take devices that have rendered a respective test result. One channel may be for devices having passed the test and one for devices having failed the test. Further channels may be provided for taking devices depending on a performance degree obtained by the electronic testing. There may also be only one channel provided, or only two channels or more than three channels. If, for instance, devices are marked, e.g. with the laser marker, they may be all unloaded into one channel and sorted at a remote position.

In each carrier portion, the devices can be held at positions that form an array. In Fig. 2a in the carrier portion 24, the three device positions on the top are arranged on a line, which is arranged perpendicular to the direction of movement upon rotation of the carrier portion 24 around the axis of rotation 2.

Due to the carrier portions being mounted rotatable they also change not only their position upon rotation, but also their orientation. In Fig. 2a, the four most outward device positions are lying on the right. If that carrier portion is rotated 90° in a counter clockwise direction, said four most outward positions are lying on the top, which means that the orientation of the carrier portion has changed in addition to the change of the position.

To unload the devices into the different channels the carrier portion at the unload position can individually free each device once a device is at a position where it can be released into the corresponding channel. The devices may be released in different steps and between each of those steps, the carrier portion is moved such that devices to be released are brought into the position, where they shall be released. During such an unloading procedure, an associated carrier portion may be loaded at the loading position and the movement between the different release steps can be used to load the devices at different positions of a carrier portion (as explained for example in more detail with respect to Fig. 6).

Figure 2b gives a schematic view of a carrier portion designed to transfer devices in a two dimensional array of positions. In the example of Fig. 2b the array is a 3 by 4 array. Other configurations of an array are possible as well such as a 2 by 4 or 2 by 5 array or the like. Said carrier portion includes four device positions all having the same distance d to the axis of rotation and four device positions all having the same distance e to the same axis, wherein d is different to e. Upon rotation of the carrier portion the devices with the distance d to the axis of rotation will all follow one after the other. They follow the same path. This path is more inward than the path the devices with a distance e to the rotation axis have. The more inward path is neighbouring the more outward path.

In Figures 2a and 2b, the associated carrier portions are joined to each other by elongated arms. These arms form respective three-pronged stars 20 and 21 which, at their centre point, are mounted rotatable with respect to the rotation axis 2. The turrets here are given by the stars 20, 21.

In Fig 2a, the carrier portions are provided in a rotational symmetry, here, as an example, in a threefold symmetry. Thereby the same configuration is achieved each time the carrier portions are rotated 120°.

Figures 3a, 3b and 3c each give another schematic view of an assembly of a test position T, a loading position L, an unloading position U and waiting positions W with respect to an exemplary rotary type handler. Therein, the further assemblies (i.e., the visual controls and the laser marker as shown in Figure 2a) are not shown for clarity, but can be provided in any case. According to Figures 3a and 3c, the assembly is such that each of a test, loading and unloading position can be reached at the same time by carrier portions associated in a fixed relation with each other. In addition, carrier portions associated with each other can also reach three waiting positions contemporaneously. The transfer from said waiting positions to the respective serving position (test, load or unload) close by can be done, in the situation of Figure 3a, by a circular rotation, possibly including a movement parallel to the rotation axis (e.g. for plugging devices into a test apparatus). To the contrary, in the situation depicted in Figure 3c, said transfer movement has to include a radial component. The transfer could be done by moving only the waiting carrier portions, while no rotational movement is done. E.g. the turret, which is coupled with the respective carrier portion, remains fixed.

In the situation of Figure 3b, the loading position L and the unloading position U can be reached at the same time by a first and a second carrier portion associated with each other, whereas, at this same time, the test position T cannot be reached by the third associated carrier portion. At the test position, there can be another carrier portion, which can rotate independently. Other placements of the respective positions with respect to each other are possible.

Figures 4a and 4b illustrate two moments of the operating cycle of an exemplary turret handler, which can be loaded by making use of gravity. Consequently, the bowl feeder (not shown) can supply the devices to the upper end of the carrier portions from where they can fall into slots which, at their lower end, are closed by stoppers 49a and 49b to hold the devices inside the carrier portion. At the unloading position (not shown), these stoppers could be such that they can be opened to drop the tested devices into the mouth respective to their obtained test result.

Each carrier portion of the shown turret handler has two further carrier portions associated therewith. The carrier portions associated with each other are respectively coupled with a three-pronged star that can circularly rotate around the rotation axis 2. These mounted stars 40 and 41 are on different levels with respect to the rotation axis. The stoppers 49a and 49b of the corresponding carrier portions are such that they adjust this difference, by holding the respective devices all at the same level. Therefore, the necessity of moving the carrier portions parallel to the rotation axis in order to make the carried devices reach a fixed serving position can be avoided. Such a movement is nevertheless possible.

The turrets 40 and 41 can rotate independently of each other, but both with respect to the common rotation axis 2. The represented turret in combination with the carrier portions is adapted for the configuration shown in Figure 3c, as the respective carrier portions, in addition to the rotation movement adopted from the stars, can also move radially. For this purpose, the carrier portions are coupled with their respective stars by bars, which can be moved outwards radially. This is an example of the carrier portions being connected indirectly with its turret. The radial movement might be realised by separate tube systems inside each of the stars 40 and 41 and of a respective part of the rotation axis, where each tube system is filled with gas or a liquid, such that an upwards or downwards motion of a plunger at the rotation axis could respectively provoke a pressing out or a sucking in of the carrier portions.

Concerning the radial movement, each carrier portion 43, 44, 45, 46, 47 may by actuated independent of the other carrier portions associated therewith, or all carrier portions associated with each other may be moved inwards or outwards in a coupled fashion. The inward/outward movement may also be possible without having a turret or a star shaped turret.

Carrier portions that are coupled with the upper star 40 are held by a bar at their upper end, whereas carrier portions that are coupled with lower star 41 are held at their lower end. This facilitates that the carrier portions of each of the stars fits into a position radially further inward than a carrier portion coupled with the respective other star.

In Figure 4a, carrier portion 45 and the carrier portions 43 and 44 associated therewith are each located at a larger distance to the rotation axis 2 (further outward) than carrier portion 47 and the carrier portions associated therewith (which are located further inward). The latter carrier portions could be at a waiting position. Figure 4b depicts a later moment in the operating cycle, when star 40 has rotated counter clockwise and, in addition, the distance of the coupled carrier portions 43, 44 and 45 to the axis 2 is reduced. On the other hand, the distance between the axis and the carrier portions coupled with star 41 is increased, such that these carrier portions could be handled, respectively, at the loading, testing and unloading position. By increasing the distance, the carrier portion with devices to be tested is moved from its waiting position to the test position and with the same movement the devices may also be plugged into the test apparatus. During the operations of loading, testing and unloading, carrier portion 45 and the carrier portions associated therewith can each move towards their next waiting position.

With carrier portion 44 it will also be possible to have more than one device in each slot. This is an example of the case where devices in one carrier portion can be moved on neighbouring paths without one path being further inward then another path, since a device which in Fig. 4 is on top of another device will follow a path which is neighbouring and above the path of the lower device. Both paths have the same distance to the rotation axis 2.

Figures 5a and 5b provide two views of a rotary type handler having two carrier portions 54 and 56. Each of the carrier portions is the extension of a respective bar shaped turret 50 and 51, and these turrets (bars) are mounted rotatable with respect to rotation axis 2. Bar 50 is longer than bar 51 and is provided with an extension parallel to the rotation axis 2 so that bar 50, its extension and the coupled carrier portion 54 can embrace bar 51 and its coupled carrier portion 56, i.e. so that both carrier portions 54 and 56 fit above one another without conflicting with the respective bars. Here each carrier portion 54, 56 and the turret 50, 51 to which the carrier portions are coupled can be mounted such that they can rotate a full 360° turn without interfering with each other.

Each carrier portion is loaded with devices 3. In Figure 5a, carrier portion 54 is at the test position T, whereas carrier portion 56 is at a waiting position above carrier portion 54 and, thus, above the test position. Figure 5b shows the same turret handler when carrier portion 56 has moved down to the test position, whereas carrier portion 54 has made one turn (in particular, even though not shown, it has passed the unloading and the loading positions) and is now situated in the waiting position above carrier portion 56 and the test position.

Bars 50 and 51 are indicated to be able to independently move helically upwards and vertically up- and downwards. This could be technically realised by appropriate guide grooves in the shaft 52 representing the rotation axis 2.

In Figure 6a, four steps of a possible loading operation are shown. Here each device is loaded one after the other. Carrier portion 65 includes twelve positions for loading devices 3, which are arranged in an array. At each position, a small hole of a suction system is indicated which may hold a device 3. The suction system of each hole may be operated independently so that devices may be hold or released independently of other devices of the same carrier portion. In Fig. 6aI, a loading shuttle 69 supplies a device firstly at a position with a minimal distance with respect to the rotation axis (not shown). Next, in Figure 6aII, the loading shuttle supplies a device to a less near position, and in step III, a further device is supplied to an even more far position. After this, the carrier portion rotates, and the loading shuttle 69 recommences loading a device at a position having minimal distance to the rotation axis, as shown in Figure 6alV. The rotation movement done by the carrier portion (e.g. transmitted by a turret) is indicated to be clockwise, to the contrary of the rotation direction as indicated in the other figures. As mentioned above, the invention comprises both possibilities independent of the particular type of carrier portion.

Figure 6b depicts a possible way of providing the loading shuttle 69 with a device: By a (e.g. radial) movement (with respect to the rotation axis of the carrier portion or turret), shuttle 69 may reach the mouth of the bowl feeder 68, which ejects a device onto the shuttle. A fixing assembly (not shown) ensures that the device 3 remains at its planned position within the shuttle. By a further (e.g. radial) movement of the shuttle, the device can then be supplied to its target position in the carrier portion as described above. As carrier portion 65 will rotate for the loading, the movements of shuttle 69 between the mouth of the bowl feeder and the respective position at the carrier portion could always reduce to a motion along the same line such as e.g. a radial one, regardless of the position within the carrier portion at which a device is to be loaded. During the rotation of the carrier portion 65 from the position as shown in Fig. 6aIII to the position of Fig. 6aIV another carrier portion may remain fixed in a test position. In the case described with respect to Fig. 6 all devices are load one by one or in other words one after the other. Nevertheless a group of devices is given, wherein inside of each group the devices are loaded one by one (first three devices) but between each group the carrier portion moves further such that another group of devices can be loaded into a row of the array. Instead of holes of a suction system at each position for a device, each position may be provided with a suction head, which can be moved individually (e.g. upwards/downwards) in order to pick up or release one individual device. The suction effect of each suction head can be operated independently of the other suction heads.

Figures 7a, b, and c display three steps of an alternative loading procedure. A rotary type handler alike that shown in Figure 1 is depicted. Devices 3 are supplied in triplets on a rotating star S at a loading position. In the first step, carrier portion 16 picks up a first triplet of devices. Carrier portion 16 then rotates with respect to rotation axis 2, while at the same time the loading star S rotates, to supply a further triplet. Carrier portion 16 picks up the second triplet and rotates again, just as the star, to supply and pick up, respectively, a further device triplet. Instead of triplets other multiplets may be loaded in this way. Here groups of devices are loaded, wherein all devices of one group are loaded at the same time while groups of devices are loaded one group after the other.

The positioning of the triplets (or in general, of multiplets) onto the star might be realised by three (or less or more) different bowl feeders each responsible for one of the inner, the middle (or one of the middle positions) or the outer device position on the star S. Said bowl feeders might feed each a different ray of the star, such that every ray would be loaded successively in three steps interrupted by a respective rotation of the star. Alternatively, the devices might be picked up by one or more suction assemblies (not shown) from a further position and placed onto the star. In any case, the star provides for a dispersed arrangement of the one or more bowl feeders and the rotating carrier portions. A multiplet (here as an example, a triplet) of devices may further be provided to the star S by taking a plurality of devices supplied in a line by a single bowl feeder.

Instead of a star S for providing a multiplet of devices to a carrier portion, a shuttle (as shown e.g. in Fig. 6) adapted for receiving a multiplet may be used for supplying the devices to a carrier portion. The multiplet may be received from one bowl feeder.

Figure 8 illustrates an exemplary rotary type handler capable of taking and transferring devices 3 that are situated each within a respective pallet 4, wherein the carrier portion can take the pallets as a whole. Carrier portions 84 and 86 each are coupled with a disk (turret) which is mounted rotatable, wherein both disks can rotate independently of each other preferably with respect to the same rotation axis. Each carrier portion is associated with two further carrier portions. In the shown embodiment, the loading position L and the unloading position U can be contemporaneously reached by carrier portions associated with each other, whereas the test position T cannot be reached by a carrier portion at the same time at which carrier portions associated therewith reach the loading or unloading position. At the moment depicted in Figure 8, a pallet is being loaded at carrier portion 85 and another pallet is being unloaded from carrier portion 83, where both carrier portions 83 and 85 are associated with carrier portion 84. The carrier portion 84 is for example in a waiting position of the test position T. The devices carried by carrier portion 86 are at the test position, and one of the carrier portions 87 and 88 associated with carrier portion 86 is already provided with devices 3, whereas the other one is empty.

The carrier portions might pick up and hold the respective pallets by suction heads, and the pallets might be supplied to and, after being unloaded, brought away by a band conveyor or a shuttle.

## Claims

1. A rotary type handler for handling electronic devices for testing, comprising at least two carrier portions (14, 16, 25, 26, 45, 46, 54, 56, 65, 84, 86) each for transferring devices (3) from a loading position (L) to a test position (T) and from there to an unloading position (U), wherein each carrier portion is mounted rotatable **characterised in that,** the at least two carrier portions can rotate independently of each other.

2. The rotary type handler of claim, **characterized in that** two turrets (10, 11, 20, 21, 40, 41, 50, 51) are provided to each of which a carrier portion (14, 16, 25, 26, 45, 46, 54, 56, 65, 84, 86) is coupled, wherein the two turrets preferably can rotate independently of each other.

3. The rotary type handler of claim 1 or 2, **characterised in that** each carrier portion is coupled in a fixed relation with one, two or more further carrier portions (13, 15, 17, 23, 25, 28, 43, 45, 47, 83, 85, 87, 88).

4. The rotary type handler of claim 3, **characterised in that** carrier portions (13, 15, 17, 23, 25, 28, 43, 45, 47, 83, 85, 87, 88) are coupled such with each other that devices transferred by one of the carrier portions can be tested while another carrier portion coupled thereto, can be loaded
and/or
that one of the carrier portions can be loaded while another carrier portion coupled thereto can be unloaded.

5. The rotary type handler of any of claims 1 to 4, **characterised in that** each carrier portion can transfer, at the same time, more than 1, 3, 4, 5 or 10 devices, wherein preferably 4 or more than 4, 5 or ten devices can be arranged in a two-dimensional array.

6. The rotary type handler of any of claims 1 to 5, **characterised in that** each carrier portion can transfer, at the same time, more than 1, 3 or 5 devices (3), which all upon rotation of the carrier portion follow one after the other.

7. The rotary type handler of one of claims 5 or 6, **characterised in that** at least two of the devices (3) transferred at the same time by a carrier portion are moved on neighbouring paths upon rotation of the carrier portion, wherein one of the neighbouring paths is further inward than another path upon rotation of the carrier portion or the two paths are parallel without one being further inward than the other, such as e.g. with the same distance to an axis of rotation (2).

8. The rotary type handler of any of claims 5 to 7, **characterised in that** the handler is adapted for loading each carrier portion at once with all of the devices (3) to be transferred therewith, or
in various groups of two of more devices (3), wherein the devices (3) of each group can be loaded at once or in consecutive steps one device after the other and the groups are loaded in consecutive steps or
all devices can be loaded one by one.

9. The rotary type handler of any claim 8, **characterised in that** a carrier portion can be rotated between the loading of two groups of devices or between the loading of two devices for positioning devices at different positions of a carrier portion.

10. The rotary type handler of any of claims 5 to 8, **characterised in that** the devices to be transferred by a carrier portion can be placed in one or more pallets (4) which are supplied to and taken by the carrier portion as a whole.

11. The rotary type handler of claim 10, **characterised in that**, after the devices of the one or more pallets have been tested, the whole pallets can be removed at the unloading position, for sorting the devices at a remote position.

12. A method for transferring devices from a loading position (L) to a test position (T) and, after the devices have been tested, to an unloading position (U), wherein a first and a second carrier portion of a rotary type handler each transfer one or more devices (3) and are mounted rotatable **characterised in that** the two carrier portions rotate independently of each other.

13. The method of claim 12, **characterised in that**
while the one or more devices transferred by the first carrier portion are being tested at the test position, the second carrier portion, which has been loaded with devices that are to be tested at the test position, is situated at a waiting position (W) immediately next to the test position; or
while one of the carrier portions is being loaded at the loading position, a second carrier portion, which is to be loaded at the loading position, is situated at a waiting position (W) immediately next to the loading position.

14. The method of claim 12 or 13, **characterised in that**
the carrier portion's movement from the waiting position immediately next to the test position towards the test position and the movement to plug-in the devices into the testing apparatus are combined into a one-directional movement
or the carrier portion's movement from the waiting position immediately next to the loading position towards the loading position and the movement to pick up one or more devices at the loading position are given by a single movement in one direction.

15. The method of any of claims 12 to 14, **characterized in that** the first carrier portion is loaded with one device or a group of devices where after it is rotated and loaded with a further device or group of devices, preferably while the second carrier portion is maintained fixed such as e.g. in the test position.
